Europäisches Patentamt

European Patent Office

Office européen des brevets

(11) Publication number : **0 551 185 A2**

# (12) EUROPEAN PATENT APPLICATION

(21) Application number : **93300064.8**

(22) Date of filing : **06.01.93**

(51) Int. Cl.$^5$ : **H01L 29/73, H01L 21/331**

(30) Priority : **07.01.92 JP 818/92**

(43) Date of publication of application :
**14.07.93 Bulletin 93/28**

(84) Designated Contracting States :
**DE FR GB**

(71) Applicant : **KABUSHIKI KAISHA TOSHIBA**
**72, Horikawa-cho Saiwai-ku**
**Kawasaki-shi Kanagawa-ken 210 (JP)**

(72) Inventor : **Morizuka, Kouhei, c/o Intellectual**
**Property Div.**
**Toshiba Corporation, 1-1-1, Shibaura,**
**Minato-ku**
**Tokyo (JP)**
Inventor : **Endo, Takahiko, c/o Intellectual**
**Property Div.**
**Toshiba Corporation, 1-1-1, Shibaura,**
**Minato-ku**
**Tokyo (JP)**

(74) Representative : **Waldren, Robin Michael et al**
**Marks & Clerk, 57-60 Lincoln's Inn Fields**
**London WC2A 3LS (GB)**

(54) **Heterojunction bipolar transistor.**

(57) A heterojunction bipolar transistor and is des-
cribed which includes an emitter layer formed
on a substrate. A wide bandgap base layer and a
light doped layer are formed on the emitter layer
by sequential epitaxial growth. An emitter layer
may be either deposited by chemical vapor
deposition on the lightly doped layer or may be
ion implanted into the lightly doped layer.

FIG.1

The present invention relates to a very small scale heterojunction bipolar transistor which can operate at high speed.

High speed operation of a bipolar transistor can be achieved by reducing base transit time and increasing the density of operation currents. These characteristics can be improved by adjusting vertical parameters of the bipolar transistor. For example, base transit time may be improved by making the base region thinner, and the density of operation currents can be improved by increasing impurity concentrations of the emitter and collector regions.

High speed operation can also be achieved by adjusting horizontal parameters of the bipolar transistor. For example, very dense circuits have been manufactured in which the circuit elements are reduced in size. Reduced device size correspondingly reduces parasitics, such as parasitic capacitance, thereby increasing the speed of operation.

In a conventional bipolar transistor, the base and emitter are formed by a double diffusion method. In the double diffusion method, a first conductivity type base region is formed by an ion implantation method or a diffusion method in a predetermined area of a layer having a second conductivity type (i.e., collector) and then an emitter region having the second conductivity type is selectively formed by ion implantation or diffusion into the base region. Recently, a self-aligned selective diffusion method has been used to fabricate a very small scale transistor in which parasitic capacitance and parasitic resistance have been reduced.

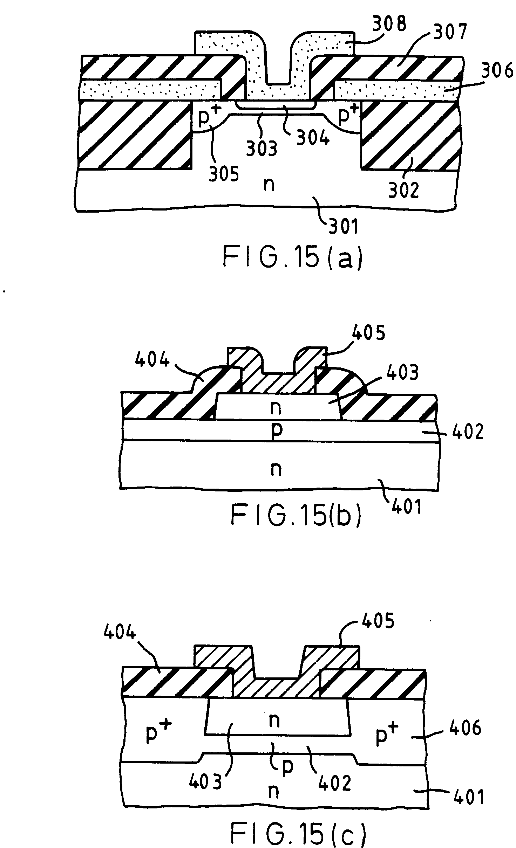

FIG. 15(a) shows an example of the conventional bipolar transistor fabricated as described above. A first thick oxide layer 302 is formed on n-type substrate 301. Substrate 301 serves as a collector. In a region surrounded by the thick oxide layer, a p-type base layer 303 and an n-type emitter layer 304 are diffused by a self-alignment method through a window formed in high impurity concentration poly-silicon layer 306. Poly-silicon layer 306 serves as a base pulling out electrode. Poly-silicon layer 306 is covered by a second oxide layer 307. Emitter region 304 is formed by diffusion of impurities from high impurity concentration poly-silicon layer 308. Poly-silicon layer 308 serves as an emitter electrode. A p-type outer base layer 305 is formed by diffusion of impurities from high impurity concentration poly-silicon layer 306.

The above-described bipolar transistor does not require an alignment margin for emitter layer 304. Accordingly, a very small scale bipolar transistor can be manufactured. That is, the transverse parameter described above can be improved by the self-aligned selective diffusion method. However, a problem remains with regard to achieving high speed operation by adjusting the vertical parameters described above. In particular, as noted above, the base region should be made thin in order to reduce the transit time of carriers across the base region. In addition, the concentration of impurities in the base region must be high to avoid deterioration in breakdown voltage by base-punch-through. On the other hand, in the double diffusion method, the emitter concentration is necessarily higher than the base concentration. Therefore, the concentration of impurities in the base region must have an upper limit in order to provide a wide range of base-emitter operational voltages and to suppress tunnel currents. In a silicon transistor, fabricated using the double diffusion method, the upper limit of the base concentration is approximately $10^{19}$ cm$^{-3}$, so that a lower limit in thickness of the base layer is at least about 50nm in order to avoid complete depletion of the base in active mode operation of the device. Accordingly, it is difficult to obtain a cut-off frequency at more than 50 GHz.

To solve this problem, formation of a hetero emitter by an epitaxial growth method has been considered. According to this method, a first conductive base layer is formed on a predetermined region of a second conductive collector layer by an epitaxial growth method. Then, an emitter layer having the second conductivity type, which has a larger forbidden band or band gap than that of the base layer, is formed on the base layer by an epitaxial growth method. In this method, since the band gap of the emitter layer is larger than that of the base layer, a sufficient injection coefficient can be insured, even if the emitter concentration is lowered to the base concentration. Therefore, relative to the double diffusion method, the base concentration can be increased and the cut-off frequency can be improved by reducing of the base width.

However, according to this method, a successive epitaxial growth steps must be performed for fabricating the base and emitter layers to obtain a high quality heterojunction which has a low interface defect density between the base and the emitter. In a successive epitaxial growth process, the sample is placed in a reactor, such as an MBE reactor, a first layer is formed by allowing permitting emission from elemental sources of the reactor. A second layer is then formed by altering the emissions of the elemental sources, without removing the sample from the reactor during the deposition of the first and second layers.

Accordingly, the selective formation of an emitter layer, which can be achieved in a conventional selective diffusion process, cannot be used. Thus, it is difficult to improve the vertical parameters (e.g., reducing parasitics) to achieve high speed operation.

This point is described in detail below with reference to FIGS. 15(b) and 15(c). Bipolar transistors, as shown in FIGS. 15(b) and 15(c), are both formed using a wafer having a p type base layer 402 and an n type emitter layer 403 formed on an n type collector 401 by successive epitaxial growth steps. In FIG.

15(b), the configuration of the emitter region is determined by a mesa etch and an oxide layer 404 is formed over the mesa etched portion. A contact hole or window is then formed in oxide layer 404 and an emitter electrode 405 is formed to connect emitter region 403 through the window of oxide layer 404. In FIG. 15(c), an emitter region is defined by forming a $p^+$ outer base layer 406 by an ion implantation method.

In both of FIGS. 15(b) and 15(c), an alignment margin for the emitter region is needed. It is therefore difficult to form the emitter region having reduced size.

Moreover, when adjusting vertical parameters to achieve high speed by using the hetero-emitter structure, as the doping concentration becomes higher, low temperature processing steps are required to keep the doping profile sharp. However, many diffusion processes used to manufacture bipolar transistors, such as the conventional double diffusion method, are performed at high temperatures, e.g. in excess of 1000°C.

Conventional bipolar transistors described above therefore cannot satisfy adjustment of both vertical and transverse parameters, to achieve high speed small scale bipolar transistors.

The object of the present invention is to provide a heterojunction bipolar transistor, which can be formed in a very small scale and can achieve high speed operation.

To attain the object of the invention, there is provided a semiconductor device which comprises: a substrate including silicon; a first layer having a first conductivity type disposed on said substrate, said first layer including silicon; a second layer having a second conductivity type disposed on said first layer, said second layer including: silicon and germanium; and carriers of the second conductivity type; a third layer disposed on said second layer, said third layer including silicon and being lightly doped; and a fourth layer having the first conductivity type disposed on said third layer, said fourth layer including silicon; and interface states being located at an interface of said third layer and said fourth layer, wherein said third layer substantially reduces a recombination of said carriers of the second conductivity type with said interface states.

Further, in accordance with the present invention, a semiconductor device is provided with comprises: a substrate including silicon; a first layer having a first conductivity type, said first layer being disposed on said substrate, said first layer including silicon; a second layer being doped with impurities of a second conductivity, said second layer being disposed on said first layer, said second layer including silicon and germanium; a third layer disposed on said second layer, said third layer including silicon and being lightly doped; and a fourth layer being doped with impurities of the first conductivity type, said fourth layer being disposed on said third layer, said fourth layer including silicon, wherein an increased concentration of the impurities of the first conductivity type and the impurities of the first conductivity type, of said fourth layer does not result in a corresponding increase in a recombination current and a tunneling current of said semiconductor device.

In addition, in accordance with the present invention, a process for manufacturing a semiconductor device is provided which comprises the steps of: forming a first layer having a first conductivity type on a substrate; sequentially epitaxially growing a continuous single crystal structure, the continuous single crystal structure including: a first single crystal region having a first concentration of impurities of a second conductivity type; and a second single crystal region having a second concentration of impurities, wherein the first concentration of impurities is greater than said second concentration of impurities; and forming a second layer on said continuous single crystal structure, said second layer having the first conductivity type.

Moreover, in accordance with the present invention, a process for manufacturing a bipolar transistor is provided which comprises the steps of: forming a collector region on a substrate; forming a base region on said collector region; forming a lightly doped region on said base region; forming an emitter region on said lightly doped region, said emitter region being self-aligned with said lightly doped region.

Further, in accordance with the present invention, a process for manufacturing a semiconductor device is provided which comprises the steps of: forming a collector layer on a substrate; sequentially epitaxially growing a continuous single crystal layer, said continuous single crystal layer including: a base layer; and a lightly doped layer; and forming an emitter on said lightly doped layer, said emitter being self aligned with said lightly doped layer.

Further, in accordance with the present invention, a bipolar transistor is provided that comprises: a substrate; a collector disposed on said substrate, said collector having a first conductivity type and including silicon; a continuous single crystal layer having been sequentially epitaxially grown, said continuous single crystal layer including: a base including silicon and germanium; and a light doped region including silicon; an emitter disposed on said lightly doped region, said emitter being self-aligned with said lightly doped region.

The other objects and advantages of the invention will be apparent from the following description, taken in conjunction with the accompanying drawings, in which:

FIG. 1 is a sectional view of an embodiment according to the present invention.

FIG. 2 to FIG. 9 are sectional views at different stages of a process according to the present invention for fabricating the bipolar transistor shown in FIG. 1.

FIG. 10 is a graph to explain characteristics of the embodiment shown in FIG. 1.

FIGS. 11(a) and 11(b) are graphs to explain characteristics of the embodiment shown in FIG. 1.

FIG. 12 to FIG. 14 are sectional process views to explain another process, in accordance with the present invention, for manufacturing a bipolar transistor according to the second embodiment of the present invention.

FIGS. 15(a), 15(b), and 15(c) are sectional views of conventional bipolar transistors.

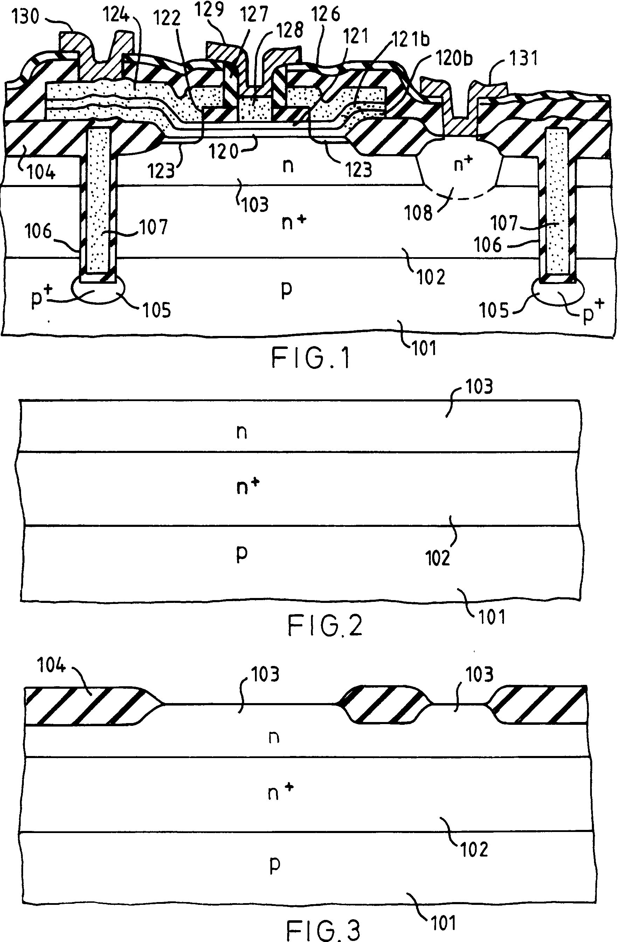

FIG. 1 is a schematic sectional view of a silicon/silicon-germanium (Si/SiGe) heterojunction bipolar transistor according to a first embodiment of the present invention.

A wafer, having an $n^+$ type silicon (Si) sub-collector layer 102 and an n type Si collector layer 103 are formed by a successive or sequential epitaxial growth method on a $p^-$ type Si substrate 101.

A LOCOS (local oxidation of silicon) oxide layer 104 is formed so as to surround a predetermined device region on Si substrate 101.

A 30 nm $p^+$ type $Si_{0.9}Ge_{0.1}$ base layer 120 and a 30 nm $p^-$ type Si layer 121, which has a lower concentration than that of $p^+$ type $Si_{0.9}Ge_{0.1}$ base layer 120, are formed on n type collector layer 103 by using a sequential epitaxial growth method. An n type poly Si emitter layer 128 is selectively formed on $p^-$ type Si layer 121.

FIG. 2 - FIG. 9 show schematic sectional process views of the first embodiment. As shown in FIG. 2, a 1.5 μm thick $n^+$ type Si sub-collector layer 102 and a 0.6 μm thick n type Si collector layer 103 are formed on a $p^-$ type Si substrate 101 by epitaxial growth. Next, as shown in FIG. 3, a LOCOS oxide layer 104 is formed so as to define base and collector contact regions.

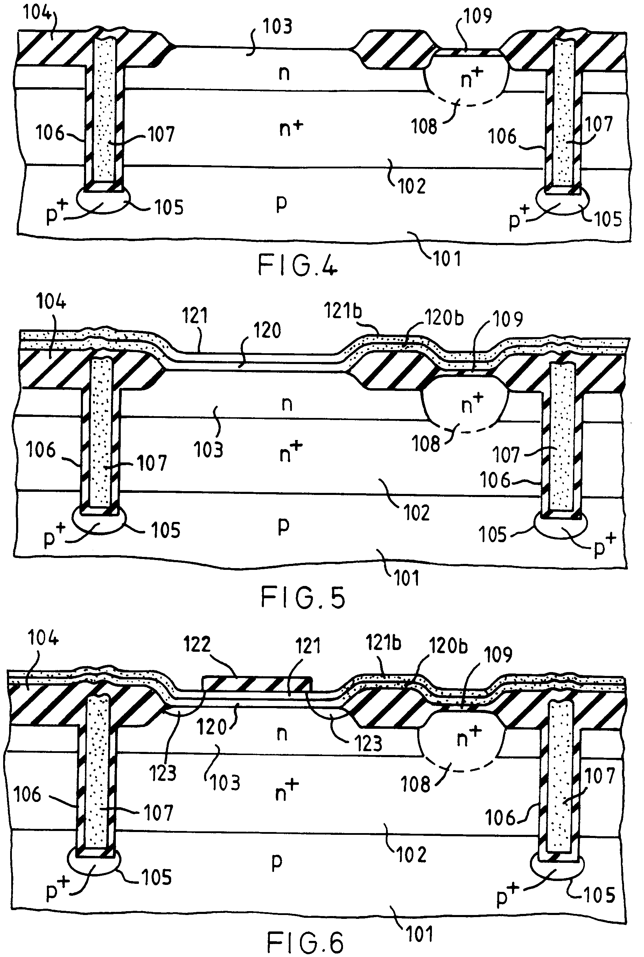

As shown in FIG. 4, an $n^+$ type collector contact diffusion layer 108 is then formed by an As ion implantation. In addition, deep trenches are formed at two predetermined portions of the LOCOS oxide layer, so as to reach $p^-$ type Si substrate 101. An oxide layer 106 is formed on the walls of the trenches and a poly Si layer 107 is formed to fill in the deep trenches. At the bottom of the trenches, $p^+$ type layers 105 serve as channel stops formed by boron (B) ion implantation before the deep trench is filled with oxide layer 106 and poly Si layer 107.

After a 50 nm thermal oxide layer 109 is formed on portions of n type collector layer 103, thermal oxide layer 109 is selectively etched away by known photolithography and chemical etching techniques. As a result, the surface of n type collector layer 103 upon which a base region is to be formed is exposed.

In the next step, a native oxide layer formed on n type collector layer 103 is removed by immersing the wafer in an aqueous hydrogen fluoride solution. Thereafter, as shown in FIG. 5, a $p^+$ type $Si_{0.9}Ge_{0.1}$ base layer 120 and a p type Si layer 121 are successively formed or sequentially epitaxially grown using a gas source molecular beam epitaxy (MBE) technique at a temperature of 550°C. An example of the sequential epitaxial growth process for forming a single crystal structure in accordance with the present invention will now be described.

In a first step of the sequential epitaxial growth process, silicon and germanium sources emit these elements in the gaseous phase and in appropriate amounts to form $Si_{0.9}Ge_{0.1}$ base layer 120. Base layer 120 is doped $P^+$ by reaction of a boron containing gas such as diborane ($B_2H_6$) and has a boron concentration of a $2 \times 10^{19}$ cm$^{-3}$. Preferably, base layer 120 is formed to have a thickness of 30 nm.

In a second step of the sequential epitaxial growth process, following the first step, $p^-$ type Si layer 121 is formed by terminating the germanium source while allowing the silicon source to continue to emit silicon. As a result, layer 121 is formed of silicon substantially free of germanium and layers 120 and 121 are formed as a continuous single silicon crystal structure over the exposed portion of collector layer 103. Layer 121 may be lightly doped with boron (a p-type dopant) by reacting an appropriate amount of diborane during growth of layer 121. $P^-$ layer 121 may have a boron concentration of $1 \times 10^{17}$ cm$^{-3}$ and a thickness of 30 nm.

Accordingly, in the sequential growth process of a continuous single crystal structure according to the present invention, it is not necessary to remove the wafer from the MBE chamber during the growth of layers 120 and 121. All that is required is that the germanium source be terminated and the amount of diborane gas be adjusted to appropriate levels to dope layers 120 and 121. Therefore, formation of layers 120 and 121 is relatively easy and does not require further complex processing steps.

Portions of layers 120 and 121 on n type collector layer 103 are formed as a continuous single crystal structure, but remaining portions of layers 120 and 121 on other regions, such as on LOCOS oxide layer 104, are polycrystalline, as designated by layers 120b and 121b.

A 100 nm $SiO_2$ layer 122 is then formed on the whole surface of substrate 101 using a chemical vapor deposition method.

As shown in FIG. 6, $SiO_2$ layer 122 is formed on $p^-$ layer of the continuous single crystal structure and is patterned using a known etching method. $BF_2$ is then ion-implanted at a 15 keV accelerating energy, using $SiO_2$ layer 122 on the intrinsic base region as a mask, such that exposed regions 123 have a boron concentration of $1 \times 10^{15}$ cm$^{-2}$.

Ion-implantation causes region 123 to become amorphous. However, by annealing at 600°C for 30 minutes, a solid phase re-growth is begun and the boron impurities become activated. As a result, as shown in FIG. 6, outer base region 123 (a base contact region) having a high concentration is formed.

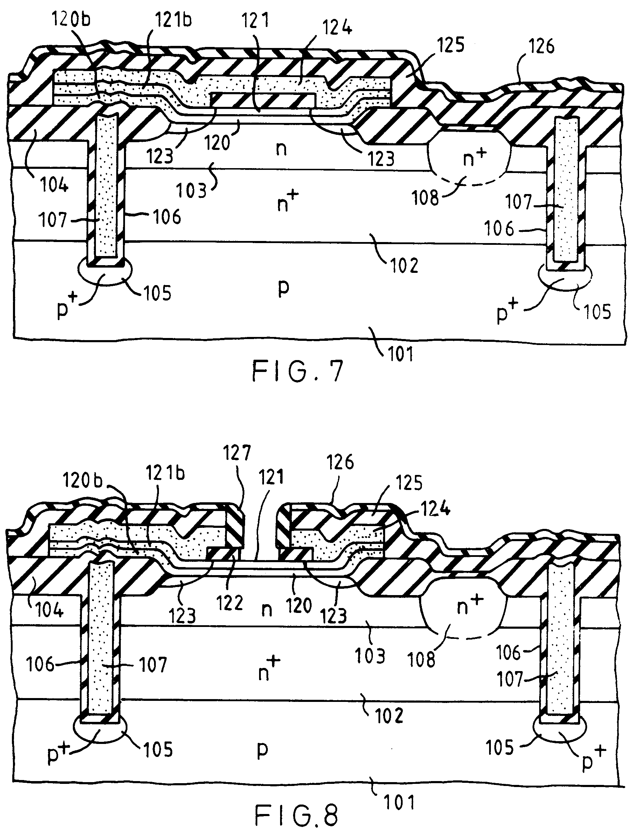

As shown in FIG. 7, a 200 nm thick boron doped poly Si layer 124 is deposited by a known low pressure CVD method at a temperature of 550°C and is patterned with poly Si layers 120b, 121b. A 300 nm SiO$_2$ layer 125 and a 100 nm SiN layer 126 are then respectively deposited on the surface of the substrate by a CVD method. As shown in FIG. 8, after forming an opening for a predetermined emitter region in SiN layer 126, as well as SiO$_2$ layer 125 and poly Si layer 124 by a reactive ion etching (RIE), a SiN layer 127 is formed on a side wall of the opening. SiN layer 127 further reduces the width of the opening, thereby further reducing the width of the emitter layer. SiO$_2$ layer 122 is then removed by a buffer solution of hydrogen fluoride (HF) to expose a surface of p$^-$ type Si layer 121.

Layer 122 protects the surface of p$^-$ layer 121 from the RIE step described above. Layer 122 is then removed by the buffered HF solution (a wet etch) which does not damage the surface of p$^-$ layer 121. Thus, the surface of p$^-$ layer 121 is not damaged throughout the etching of layers 126, 125, 124 and 122.

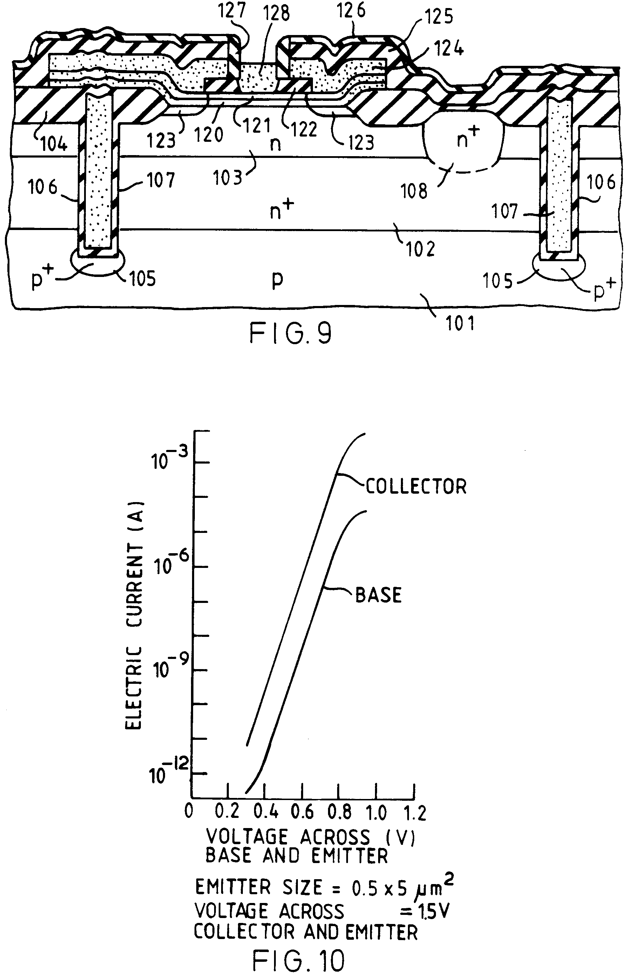

As shown in FIG. 9, a phosphorus (P) doped poly Si emitter layer 128 is then selectively deposited on the exposed p$^-$ type Si layer 121. Emitter layer 128 is therefore self-aligned with the continuous single crystal structure comprising base layer 120 and p$^-$ layer 121. In this embodiment, the concentration of electrons in poly Si emitter layer 128 is $2 \times 10^{20}$ cm$^{-3}$.

Finally, as shown in FIG. 1, openings are formed in SiN layer 126 and SiO$_2$ layer 125 for base contact and collector contact portions, respectively. Then a base electrode 130 and a collector electrode 131 are formed to contact poly Si layer 124 and n$^+$ collector contact layer 108 respectively through these openings. Emitter electrode 129 is formed to contact emitter layer 128. Electrodes 128, 129 and 130 may be made of Al/TiN/Ti.

In the first embodiment, concentrations of carriers in poly Si emitter layer 128 and SiGe base layer 120 are respectively $2 \times 10^{20}$ cm$^{-3}$ and $2 \times 10^{19}$ cm$^{-3}$. Both of these values are high concentrations. However, if these layers were in direct contact each other, a normal transistor operation could not be obtained because increased leakage currents would be caused by tunnel currents. In the above-described embodiment, a low concentration p$^-$ type Si layer 121 having a 30 nm thickness, is formed so as to be sandwiched between poly Si emitter layer 128 and SiGe layer 120. According to this structure, the intensity of the electric field between the emitter and base can be reduced to about 300 KV/cm. Therefore, device characteristics are unaffected by tunnel currents.

In the above-described embodiment, the thickness and the concentrations of the low concentration p$^-$ type Si layer 121 can be selected to satisfy conditions associated with the depletion state at equilibrium. That is,

$$| NA - ND | < \frac{2EsVbi}{qWz} \quad (1)$$

W(cm) is a thickness of the low concentrated p$^-$ type Si layer 121, NA (cm$^{-3}$) and ND (cm$^{-3}$) are an ionized acceptor concentration and an ionized donor concentration, Es (F·cm$^{-1}$) is a dielectric constant, q(C) is the amount of charge of an electron, and Vbi(V) is a diffusion or built-in voltage at an emitter-base heterojunction. If the energy of the band gap of the base layer is Eb(J),

$$Vbi \simeq Eb/q \quad (2)$$

FIG. 10 shows a graph of base current and collector current (vertical axis) vs. the voltage across the base and emitter (V$_{BE}$). As shown in FIG. 10, the device according to this embodiment of the present invention has a reduced leakage current of approximately $10^{-12}$ A (= 10 pA) when V$_{BE}$ equals approximately 0.3V. The area of the emitter was 0.5x5 $\mu$m$^2$, and the voltage across the collector and emitter was 1.5V.

In the preferred embodiment, p$^-$ type Si layer 121 is lightly doped. That is, the doping concentration of this layer is sufficiently low that it is completely depleted of carriers at equilibrium (i.e. when 0 V is applied to the emitter, collector and base electrodes). Since the energy difference of the valence bands of p$^+$ type Si$_{0.9}$Ge$_{0.1}$ base layer 120 and p$^-$ Si layer 121 is 0.1 eV, holes are confined to p$^+$ type Si$_{0.9}$Ge$_{0.1}$ base layer 120. Accordingly, the number of holes that recombine with electrons through interface states located at the p$^-$ Si layer 121/emitter interface is reduced and recombination currents are correspondingly reduced. When a bias is applied to the base under normal operating conditions, the concentration of holes that ingrate into p$^-$ Si layer is only $4 \times 10^{17}$ cm$^{-3}$. In contrast, in conventional bipolar transistors, in which the emitter layer is deposited or grown directly on the base layer, holes in the base layer are not spaced from the interface states located at the emitter/base junction. Thus, holes readily recombine with electrons through the interface states, thereby increasing the recombination current of the device.

Therefore, a high emitter injection efficiency can be achieved and a current gain of more than 150 could be achieved.

Since p$^+$ type Si$_{0.9}$Ge$_{0.1}$ base layer 120 and p$^-$ type Si layer 121 are formed by sequential epitaxial growth, very few interface states are generated and therefore recombination currents at the hetero-interface are reduced.

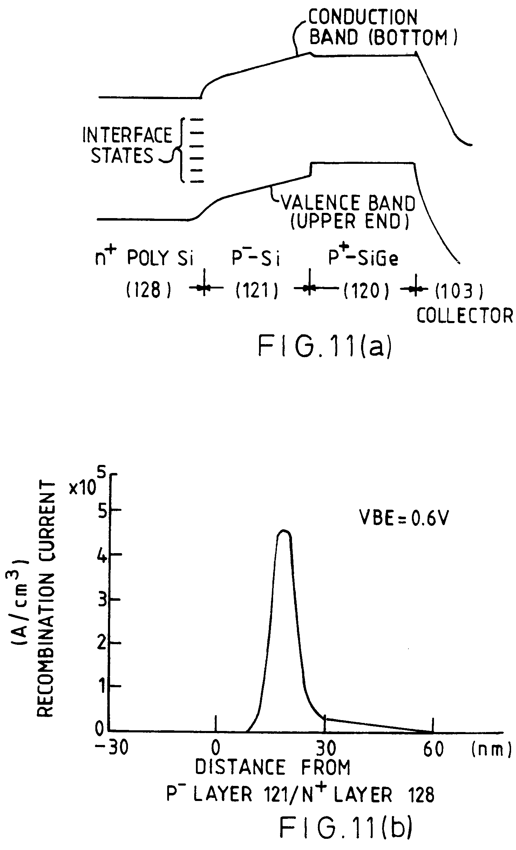

This point will be described in more detail below with reference to FIG. 11(A) which shows an energy band diagram of the transistor in accordance with the preferred embodiment. Interface states are formed at the interface of p⁻ Si layer (121) and n⁺ poly-Si layer 128 when the p⁻ Si layer is exposed to air prior to formation of layer 128. However, these interface traps are inactive as recombination centers because most of the holes in the p+ type base 120 cannot reach the interface traps for the following reasons. First, the heterojunction barrier between p⁺ SiGe layer 120 and p⁻ type Si layer 121 significantly reduces hole injection into the fully depleted p⁻ layer 121. Second, the separation between the interface states and the p⁺ Si layer 120/ p⁻ layer 121 interface further reduces the holes concentration at the interface states. Thus, since the interface state is positioned at an edge of depletion layer away from the holes in base layer 120, recombination current is reduced.

Further, as seen in FIG. 11(B) (a plot of recombination current vs. distance from the p⁻ layer 121/n⁺ layer 128 interface), recombination of electrons and holes occurs mainly in the neutral base region (12) and in the center of lightly doped p⁻ layer 121. FIG. 11(B) shows recombination away from the interface states. Such interface states facilitate recombination of electrons and holes which reduces the gain of the device. Although FIG. 11(B) shows that some recombination occurs, such recombination is less than that which would occur if holes could more readily combine with electrons through the interface traps.

In a conventional bipolar transistor, the recombination states generated at the p-n junction depletion layer of the emitter and base have several adverse effects on device performance. Therefore, an annealing out of the recombination states by a high temperature thermal process is necessary. Alternatively, the emitter region may be diffused away from the region containing the interface states and into the neutral base region such that the depletion region is formed away from the interface states. Both techniques facilitate recombination of electrons and holes (which occurs in the depletion region associated with the base emitter junction) away from the interface states. Both techniques, however, require high temperature processing steps. In addition, further diffusion of the emitter causes diffusion of impurities in the base which effectively increases the base width.

However, in accordance with the present invention, lightly doped layer 121 is disposed between base 120 and emitter 128. Layer 121 constitutes a potential barrier to the holes in base 120. The holes in base 120, therefore, are spaced from interface states adjacent the emitter layer 128. Accordingly, fewer holes recombine with these interface states and recombination currents are reduced without requiring additional annealing steps or other high temperature steps during processing.

Moreover, according to the embodiment, since the base impurity concentration may be as high as $2 \times 10^{19}$ cm⁻³, a base pinch sheet resistance (the sheet resistance of the base layer under the emitter region) can be kept low, such as 2 kΩ/square, even if the base width is only 30 nm thick. In conventional bipolar transistors, however, the base sheet resistance may be 10kΩ/square. The transistor in accordance with the present invention, has a reduced base transit time of 1.5 psec and an entire delay time from emitter to collector of 2.5 psec. The cut-off frequency more than 60 GHz was obtained with the low base resistance.

Also, since epitaxial growth is performed at 650°C and subsequent annealing steps are not necessary, a diffusion of the high concentration of boron introduced during epitaxial growth is reduced and desired device characteristics can be achieved.

The n⁺ poly Si emitter region is selectively grown in and therefore self-aligned with the opening in SiN layer 127, $SiO_2$ layer 126, and poly Si layer 124 formed by RIE. Accordingly, a very small scale device can be attained that does not need a significant alignment margin which is required in the conventional bipolar transistor described above. For example, in the above-described embodiment, the alignment margin was 0.3 μm, a minimum lithographic line width was 0.8 μm, and a thickness of SiN side wall layer 127 was 0.15 μm. So a very small device having a 0.5 μm emitter width and a 2 μm base-collector junction width can be achieved, which is comparable to that achieved by the self-aligned selective diffusion technique.

In the embodiment described above, Si layer 121 contained a concentration of boron impurities of $1 \times 10^{17}$ cm⁻³ as the low impurity layer used between high impurity n⁺ poly Si emitter layer 128 and p⁺ base layer 120. Alternatively, Si layer 121 may contain n type impurities instead of p type impurities. The impurity concentration of Si layer 121 should be selected such that it is depleted under application of voltage during normal operating conditions and cannot function as an emitter.

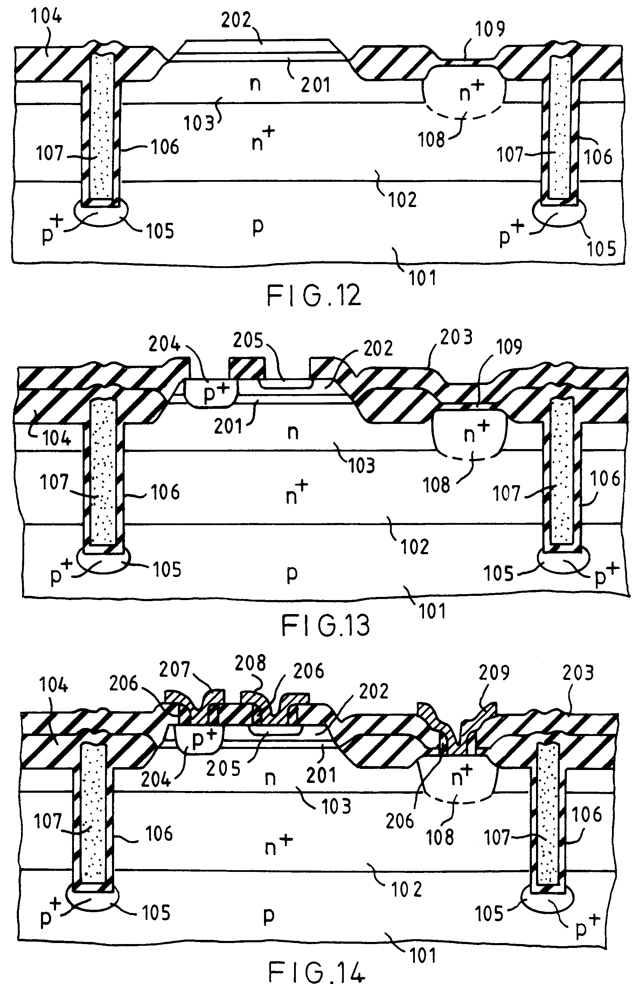

FIG. 12 to FIG. 14 show schematic sectional process views to explain another manufacturing method of the present invention. Steps for forming the low concentration collector layer and isolation region are similar to those steps shown in FIG. 2 to FIG. 4.

After the steps to form the structure shown in FIG. 4, the wafer is immersed in an aqueous hydrogen fluoride solution to remove a native oxide layer. As shown in FIG. 12, a p⁺ type $Si_{0.9}Ge_{0.1}$ base layer 201, which has a boron concentration of $2 \times 10^{19}$ cm⁻³ and a p⁻ type Si layer 202 having a boron concentration of $1 \times 10^{17}$ cm⁻³ are then sequentially epitaxially grown using a gas source MBE method at a temperature of 550°C. The thickness of $Si_{0.9}Ge_{0.1}$ layer 201 and Si layer 202 are respectively 30 nm and 100 nm. These layers are controlled at a lower pressure, compared with the first embodiment, to epitaxially selectively grow only on the exposed portion of single crystal a collector layer 103 and not on the oxide layer.

Next, as shown in FIG. 13, a 40 nm SiO$_2$ layer 203 is deposited using a CVD method, and SiO$_2$ layer 203 on a base contact region is etched away. BF$_2$ is then implanted at a 15 keV accelerative energy using SiO$_2$ layer 203 as a mask. The implanted portion contains a concentration of 10$^{15}$ cm$^{-3}$.

SiO$_2$ layer 203 on an emitter contact region is then etched away as described above. Then, using the SiO$_2$ layer 203 as a mask, As ions are implanted at an accelerative energy of 30 keV, such that the implanted portion contains an impurity concentration of 10$^{15}$/cm$^{-3}$.

After these steps, the wafer is annealed at a temperature of 800°C for 30 seconds to form a p$^+$ type outer base layer 204 and a n$^+$ type emitter layer 205, as shown in FIG. 13.

The depth of n$^+$ type emitter layer 205 is 60-70 nm, so a low impurity p$^-$ type Si layer 202 having a 30-40 nm thickness remains between p$^+$ type SiGe base layer 201 and n$^+$ emitter layer 205. As a result, the structure of this embodiment can be realized.

Next, the oxide layer on the collector contact region is etched away, and an oxide sidewall 206 is formed at a sidewall of the contact hole for the emitter, the base, and the collector. Electrodes 207, 208, 209, made of Al/TiN/Ti, are formed to complete a bipolar transistor.

Usually, there are many recombination centers caused by implantation damage at the bottom portion of n$^+$ type emitter layer 205. However, in accordance with the present invention, n$^+$ type emitter layer 205 is distanced apart from base layer having many holes by the thickness of low impurity of Si layer 202. Thus, deterioration of bipolar transistor characteristics caused by the recombination current can be reduced.

In the above embodiment, a heterojunction bipolar transistor for a Si/SiGe system is explained, but the present invention is not limited to the system. For example, a semiconductor compound of a SiC/Si system or a AlGaAs/GaAs system can be implemented to obtain similar results.

As described above, according to the invention a heterojunction carrier reduces hole current flow, therefore, a high emitter injection efficiency is insured by a large band gap layer formed on a base layer although its doping level is low. Thus, impurity concentration of the base can be set high without current gain degradation. This high doping degradation permits a reduction in the base thickness and base transit time. Also, the low concentration layer on the base layer is depleted under thermal equilibrium. Thus, improved endurance against breakdown and punch through and a decrease in leakage currents caused by tunnel currents can be achieved by electric field strength reduction.

Moreover, if the low concentration layer has the same conductivity, e.g., a first conductivity, as the base layer, the size of the emitter and base junction can be determined by providing a second conductivity type emitter layer selectively formed on the low concentration layer. The base layer and the low concentration layer, which have different band gaps, can be sequentially epitaxially grown, so the density of the interface states between the two layers can be reduced.

Therefore, if the emitter layer is selectively formed on the low concentration layer and many interface states are generated between the two layers, recombination currents caused by the interface states can be decreased because the interface state are separated from the base layer having holes. Further, because the emitter layer is not formed by diffusion, the diffusion of an impurity profile can be suppressed by processing at low temperatures.

Numerous modifications and variations of the present invention are possible in light of the above teachings. It is therefore to be understood that, within the scope of the appended claims, the present invention can be practiced in a manner other than as specifically described herein.

## Claims

1. A semiconductor device comprising:
a substrate including silicon;
a first layer having a first conductivity type disposed on said substrate, said first layer including silicon;
a second layer having a second conductivity type disposed on said first layer, said second layer including:
silicon and germanium; and
carriers of the second conductivity type;
a third layer disposed on said second layer, said third layer including silican and being lightly doped; and
a fourth layer having the first conductivity type disposed on said third layer, said fourth layer including silicon; and
interface states being located at an interface of said third layer and said fourth layer,
wherein said third layer substantially reduces a recombination of said carriers of the second conductivity type with said interface states.

2. A semiconductor device comprising:
a substrate including silicon;
a first layer having a first conductivity type, said first layer being disposed on said substrate, said first layer including silicon;
a second layer being doped with impurities of a second conductivity, said second layer being disposed on said first layer, said second layer including silicon and germanium;

a third layer disposed on said second layer, said third layer including silicon and being lightly doped; and

a fourth layer being doped with impurities of the first conductivity type, said fourth layer being disposed on said third layer, said fourth layer including silicon,

wherein an increased concentration of the impurities of the second conductivity type and the impurities of the first conductivity type of said fourth layer does not result in a corresponding increase in a recombination current and a tunneling current of said semiconductor device.

3. A process for manufacturing a semiconductor device comprising the steps of:

forming a first layer having a first conductivity type on a substrate;

sequentially epitaxially growing a continuous single crystal structure, the continuous single crystal structure including:

a first single crystal region having a first concentration of impurities of a second conductivity type; and

a second single crystal region having a second concentration of impurities,

wherein the first concentration of impurities is greater than said second concentration of impurities; and forming a second layer on said continuous single crystal structure, said second layer having the first conductivity type.

4. A process according to claim 3, wherein the second concentration is sufficiently low such that the second single crystal region is completely depleted under equilibrium.

5. A process according to claim 3, wherein said step of sequentially epitaxially growing the continuous single crystal layer includes the steps of:

epitaxially growing the first single crystal semiconductor region; and

epitaxially growing the second single crystal semiconductor region.

6. A process according to claim 5, wherein-said step of epitaxially growing the first single crystal semiconductor region includes a first molecular beam epitaxy step and said step of epitaxially growing the second single crystal semiconductor region includes a second molecular beam epitaxy step.

7. A process according to claim 6, wherein the first molecular beam epitaxy step includes the steps of:

providing a silicon source;

providing a germanium source;

allowing said silicon source to emit silicon;

and

allowing said germanium source to emit germanium; and the second molecular beam epitaxy step includes the steps of:

terminating emission of germanium from said germanium source;

continuing emission of silicon from said silicon source after said step of terminating emission of germanium; and

terminating emission of silicon from said silicon source.

8. A process for manufacturing a bipolar transistor comprising the steps of:

forming a collector region on a substrate;

forming a base region on said collector region;

forming a lightly doped region on said base region;

forming an emitter region on said lightly doped region, said emitter region being self-aligned with said lightly doped region.

9. A process according to claim 4, wherein said step of forming the emitter region includes a step of selectively epitaxially growing the emitter region.

10. A process for manufacturing a bipolar transistor comprising the steps of:

forming a collector layer on a substrate;

sequentially epitaxially growing a continuous single crystal layer, said continuous single crystal layer including:

a base layer; and

a lightly doped layer; and

forming an emitter on said lightly doped layer, said emitter being self aligned with said lightly doped layer.

11. A process according to claim 10, wherein said step of forming the emitter includes a step of selectively epitaxially growing the emitter on said lightly doped layer.

12. A bipolar transistor comprising:

a substrate;

a collector disposed on said substrate, said collector having a first conductivity type and including silicon;

a continuous single crystal layer having been sequentially epitaxially grown, said continuous single crystal layer including:

a base including silicon and germanium; and

a light doped region including silicon;

an emitter disposed on said lightly doped region, said emitter being self-aligned with said lightly doped region.

FIG.1

FIG.2

FIG.3

FIG.4

FIG.5

FIG.6

FIG. 7

FIG.8

127    128    126    125
124

104    123    120    121    122    123
n⁺

104    123    120    121    122    123

106    107    103    n    108    107    106

n⁺

102

p⁺    105    p    105    p⁺

101

FIG. 9

ELECTRIC CURRENT (A)

$10^{-3}$

COLLECTOR

$10^{-6}$

BASE

$10^{-9}$

$10^{-12}$

0    0.2    0.4    0.6    0.8    1.0    1.2

VOLTAGE ACROSS (V)
BASE AND EMITTER

EMITTER SIZE = $0.5 \times 5 \, \mu m^2$
VOLTAGE ACROSS        = 1.5V
COLLECTOR AND EMITTER

FIG. 10

FIG. 11(a)

FIG. 11(b)

FIG.12

FIG.13

FIG.14

FIG.15(a)

FIG.15(b)

FIG.15(c)